# EUROPEAN PATENT APPLICATION

(11) **EP 4 779 321 A1**
(43) Date of publication of application: **22.07.2026**
(21) Application number: 24865294.3
(22) Date of filing: 30.08.2024
(51) Int. Cl.: G01R 1/067, G01R 1/073, H01L 21/66

(54) **PROBE**

(30) Priority: 15.09.2023 JP 2023149834
(71) Applicant: Kabushiki Kaisha Nihon Micronics, Musashino-shi Tokyo 180-8508 (JP)
(72) Inventor: UMEDA, Ryuichi, Tokyo 180-8508 (JP)
(74) Representative: Samson & Partner Patentanwälte mbB
(86) International application number: PCT/JP2024/031351
(87) International publication number: WO 2025/057792

(57) **Abstract**

A probe includes a first end and a second end, which are ends in an axial direction; and a first arm and a second arm having a columnar shape and arranged in parallel in a width direction perpendicular to the axial direction to form a first slit therebetween. The first arm and the second arm extend from the first end to the second end. The first arm and the second arm are connected with each other with the first end and the second end as connection regions. In at least one of the first end or the second end, a second slit having an opening width in the width direction narrower than the first slit is formed in the connection regions in the axial direction to communicate with the first slit. Side surfaces of the second slit are formed in a tapered shape, viewed in a cross section along the width direction, and intersect obliquely with the width direction.

## Description

### TECHNICAL FIELD

The present invention relates to a probe used for inspecting the electrical characteristics of an inspection object.

### BACKGROUND ART

A probe that contacts an inspection object is used for inspecting electrical characteristics of an inspection object, such as a semiconductor integrated circuit, without separating it from a wafer. In the inspection using the probe, a load may be applied to the probe so that the probe that contacts the inspection object is elastically deformed. By elastically deforming the probe, the contact between the inspection object and the probe can be ensured due to the elasticity of the probe. A probe having a structure in which a plurality of columnar arms are arranged in parallel has been studied to adjust pressure applied by the probe that is in contact with an inspection object (see Patent Literature 1). In the probe having a structure in which the arms are arranged in parallel, a slit is formed between the arms. The end of the slit is a connecting portion between the arms.

### CITATION LIST

### PATENT LITERATURE

[Patent Literature 1] Japanese Unexamined Patent Application Publication No. 2020-143976

### SUMMARY OF THE INVENTION

### TECHNICAL PROBLEM

In a probe having a structure in which a plurality of arms are arranged in parallel, stress is concentrated at the ends of slits formed between the arms due to the curvature of the probe. The concentration of the stress may damage the probe.

An object of the present invention is to provide a probe that suppresses damages due to stress concentration on ends of slits formed between arms.

### SOLUTION TO PROBLEM

According to one aspect of the present invention, there is provided a probe including a first end and a second end, which are ends in an axial direction; and a first arm and a second arm having a columnar shape and arranged in parallel in a width direction perpendicular to the axial direction to form a first slit therebetween. The first arm and the second arm extend from the first end to the second end. The first arm and the second arm are connected with each other with the first end and the second end as connection regions. In at least one of the first end or the second end, a second slit having an opening width in the width direction narrower than the first slit is formed in the connection regions in the axial direction to communicate with the first slit. Side surfaces of the second slit are formed in a tapered shape, viewed in a cross section along the width direction, and intersect obliquely with the width direction.

### ADVANTAGEOUS EFFECTS OF INVENTION

The present invention can provide a probe that suppresses damages due to stress concentration on ends of slits formed between arms.

### BRIEF DESCRIPTION OF THE DRAWINGS

[FIG. 1] FIG. 1 is a schematic view illustrating a configuration of a probe according to an embodiment of the present invention.
[FIG. 2] FIG. 2 is a schematic perspective view illustrating a configuration of an end of a probe according to an embodiment of the present invention.
[FIG. 3] FIG. 3 is a schematic cross-sectional view in the III-III direction in FIG. 1.
[FIG. 4] FIG. 4 is a schematic cross-sectional view in the IV-IV direction in FIG. 1.
[FIG. 5] FIG. 5 is a schematic cross-sectional view in the V-V direction in FIG. 1.
[FIG. 6] FIG. 6 is a schematic view illustrating a configuration of an electrical connection device including a probe according to an embodiment of the present invention.
[FIG. 7] FIG. 7 is a schematic view illustrating a first arm and a second arm in contact with each other at second slits of a probe according to an embodiment of the present invention.

### DESCRIPTION OF EMBODIMENTS

Next, an embodiment of the present invention will be described with reference to the accompanying drawings. In the following description of the drawings, the same or similar portions are denoted by the same or similar reference numerals. However, it should be noted that the drawings are only schematic, and a thickness ratio of portions, or the like, are different from the actual ones. Needless to say, the drawings include portions in which the dimensional relationship and the ratio are different from each other. The following embodiments illustrates a device and a method for embodying the technical concept of the present invention, and the embodiments of the present invention do not specify the following materials, shapes, structures, arrangements, manufacturing methods, or the like of components.

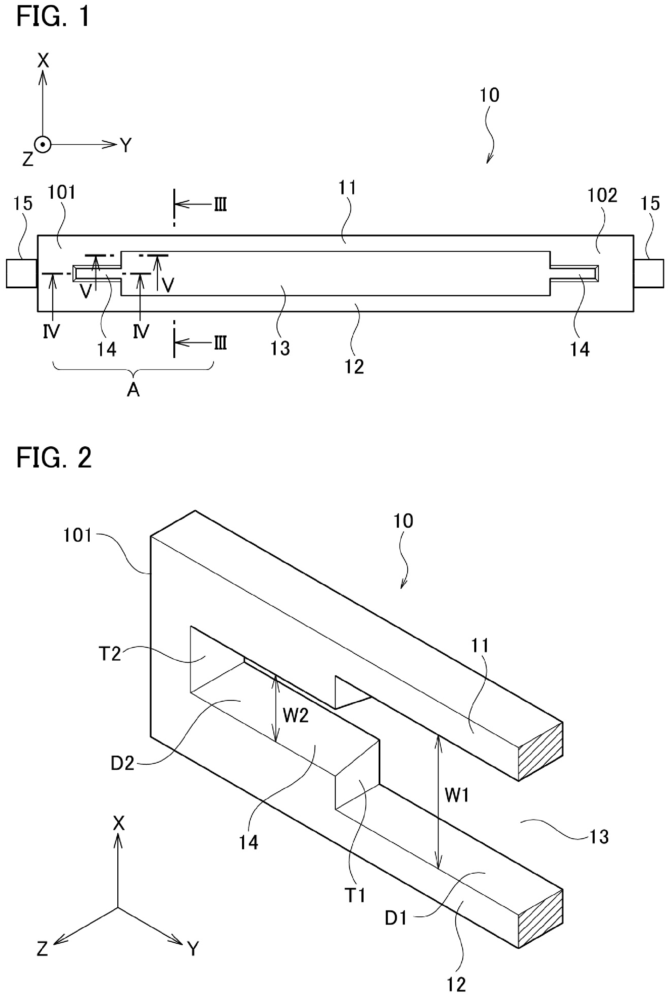

A probe 10 according to the embodiment, which is illustrated in FIG. 1, is used for inspecting electrical characteristics of an inspection object. The probe 10 includes a first end 101 and a second end 102; and a first arm 11 and a second arm 12 having a columnar shape. The first arm 11 and the second arm 12 extend from the first end 101 to the second end 102. The first arm 11 and the second arm 12 are connected with each other with the first end 101 and the second end 102 as connection regions.

As illustrated in FIG. 1, the probe 10 extends in a Y-direction which is hereinafter referred to as an "axial direction" of the probe 10. The first end 101 and the second end 102 are ends on both sides of the probe 10 in the axial direction. The first arm 11 and the second arm 12 are arranged in an X-direction which is referred to as a "width direction" of the probe 10. The width direction is perpendicular to the axial direction. Further, a Z direction perpendicular to both the Y direction and the X direction is referred to as a "thickness direction" of the probe 10.

As illustrated in FIG. 1, the first arm 11 and the second arm 12 are arranged in the width direction in parallel with each other to form a first slit 13 therebetween. Second slits 14, which have a narrower distance in the width direction (hereinafter also referred to as "opening width") than the first slit 13, are formed at a first end 101 and the second end 102 provided in connection regions along the axial direction. The first slit 13 and the second slits 14 communicate with each other. The first slit 13 and the second slits 14 penetrate the probe 10 in the thickness direction. The second slits 14 are on both the first end 101 and the second end 102 of the probe 10.

FIG. 2 illustrates an enlarged perspective view of the connection regions indicated by a region A in FIG. 1. As illustrated in FIG. 2, the opening width (hereinafter also referred to as "first opening width W1") of the first slit 13 is wider than the opening width (hereinafter also referred to as "second opening width W2") of the second slit. The second slit 14 is arranged in an intermediate region between the first arm 11 and the second arm 12, viewed in the thickness direction. In other words, the second slit 14 communicates with the first slit 13 in a region separated from a connection position in the connection region with the first arm 11 and the connection position in the connection region with the second arm 12.

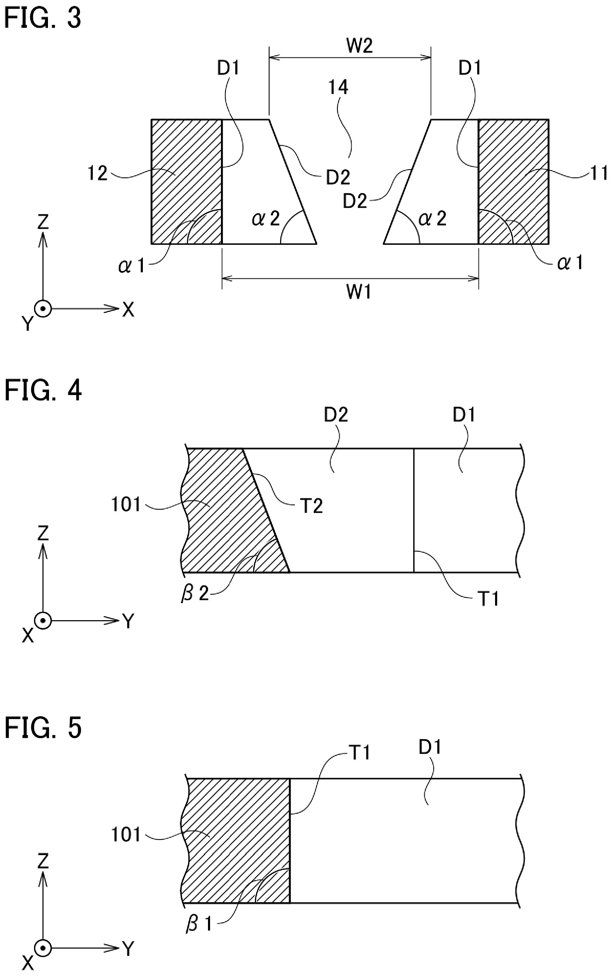

As illustrated in FIG. 3, side surfaces (referred to as "second side surfaces D2") of the second slit 14 are formed in a tapered shape, viewed in a cross section along the width direction, and intersect obliquely with the width direction and the thickness direction. An angle formed by the second side surfaces D2 of the second slit 14 and the width direction is referred to as "second side surface angle α2".

Further, as illustrated in FIG. 4, a side surface (referred to as "second end surface T2") of an end portion of the second slit 14 is formed in a tapered shape, viewed in a cross section along the axial direction, and intersects obliquely with the axial direction and the thickness direction. An angle formed by the second end surface T2 of the second slit 14 and the axial direction is referred to as "second end surface angle β2".

Further, as illustrated in FIG. 3, the angle formed by side surfaces (referred to as "first side surfaces D1") of the first slit 13, viewed in a cross section along the width direction and the width direction are referred to as "first side surface angle α1". As illustrated in FIG. 3, the first side surface angle α1 is larger than the second side surface angle α2. In other words, the first side surface D1 is formed closer to perpendicular to the width direction than the second side surface D2. For example, the first side surface D1 may be perpendicular to the width direction. In other words, the first side surface D1 may be parallel to the thickness direction.

Further, as illustrated in FIG. 5, an angle formed by a side surface (referred to as "first end surface T1") of an end portion of the first slit 13, viewed in a cross section along the axial direction and the axial direction, is referred to as "first end surface angle β1". As illustrate in FIGS. 4 and 5, the first end surface angle β1 is larger than the second end surface angle β2. In other words, the first end surface T1 is formed closer to perpendicular to the axial direction than the second end surface T2. For example, the first end surface T1 may be perpendicular to the axial direction. In other words, the first end surface T1 may be parallel to the thickness direction.

The probe 10 may be formed by patterning a substrate, which is a material for the probe 10, into a predetermined shape by etching. For example, the probe 10, in which the first arm 11, the second arm 12 and the connection regions are integrated, may be manufactured by a wet etching method using an etching mask. A plurality of probes 10 can be simultaneously cut from one substrate by a wet etching method in which the substrate is etched with an etchant. Further, the first slit 13 may be formed by the wet etching method. That is, the first slit 13 may be formed simultaneously when the probe 10 is cut from the substrate.

Incidentally, when the first slit 13 is formed by etching with an etchant, the amount of the etchant may be different between an upper surface and a lower surface of the substrate. Therefore, the etching rate may be different between the upper surface and the lower surface of the substrate. The side surfaces (the first side surface D1 and the first end surface T1) of the first slit 13 may be formed in a tapered shape obliquely inclined without being perpendicular to the width direction and the axial direction. However, when the first slit 13 is formed by wet etching, the first side surface D1 and the first end surface T1 of the first slit 13 are formed substantially perpendicular to the width direction and the axial direction.

The first opening width W1 may be, for example, about 10 µm to several tens of µm. On the other hand, the second opening width W2 may be about several µm. Since the second opening width W2 is narrow, it is difficult to form the second slit 14 by wet etching. Therefore, the second slit 14 is formed, for example, by irradiating the connection regions of the probe 10 with a laser beam (hereinafter also referred to as "laser processing"). The length of the second slit 14 in the axial direction is, for example, about several tens to several hundreds of µm.

By forming the second slit 14 by laser processing, the second side surface D2 of the second slit 14 is formed in a tapered shape intersecting obliquely with the width direction, and the second end surface T2 is formed in a tapered shape intersecting obliquely with the axial direction. The second side surface angle α2 and the second end surface angle β2 may be substantially equal. The second side surface D2 and the second end surface T2 of the second slit 14 may be formed in succession by laser processing in the same process.

As described above, the first slit 13 is formed by wet etching, and the second slit 14 is formed by laser processing, so that the second side surface angle α2 is smaller than the first side surface angle α1, viewed in a cross section along the width direction of the probe 10. Similarly, the second end surface angle β2 is smaller than the first end surface angle β1, viewed in a cross section along the axial direction of the probe 10.

As illustrated in FIG. 1, tip members 15 are arranged at the first end 101 and the second end 102 of the probe 10. The tip members 15 extend from the connection regions in a direction opposite to the direction in which the first arm 11 and the second arm 12 extend. In other words, the tip members 15 project from the tips of the first end 101 and the second end 102. The tip members 15 are made of a material having hardness higher than the first end 101 and the second end 102.

As described below, in the inspection of an inspection object using the probe 10, the tip member 15 of the first end 101 contacts the inspection object. The tip member 15 having a hardness higher than that of the first end 101 is arranged at the tip of the first end 101, so that it is possible to suppress the wear of the first end 101. Nickel (Ni), a nickel alloy, or the like, may be used as a material for the first end 101, the second end 102, the first arm 11, and the second arm 12. Rhodium (Rh), a rhodium alloy, or the like, may be used as a material for the tip member 15.

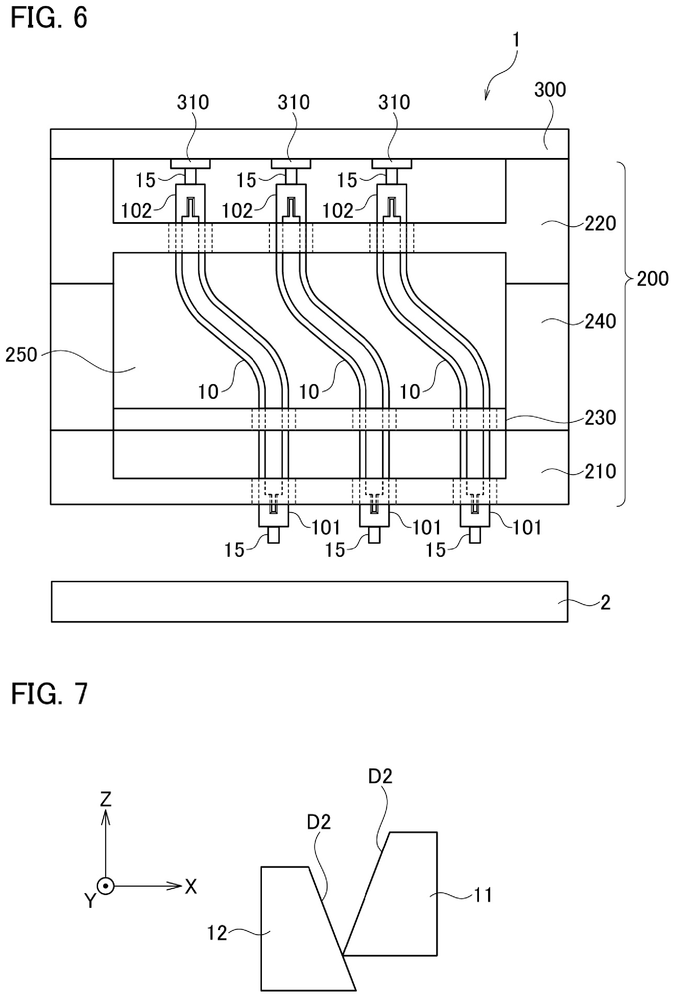

The electrical connection device 1 including the probes 10 will be described below with reference to FIG. 6. The electrical connection device 1 is used for inspecting the characteristics of an inspection object 2. The inspection object 2 is, for example, a semiconductor integrated circuit formed on a semiconductor substrate.

The electrical connection device 1 includes a probe head 200 for holding the probe 10 with the first end 101 facing the inspection object 2. The electrical connection device 1 further includes a wiring board 300. The number of probes 10 held by the probe head 200 can be set in accordance with the number of terminals of the inspection object 2, the number of inspection objects 2 that are simultaneously inspected, or the like.

The tip members 15 arranged at the second end 102 of the probes 10 are electrically connected to lands 310 arranged on the wiring board 300. The lands 310 are made of a conductive material, such as a metal. The lands 310 are electrically connected to an inspection device (not illustrated), such as a tester. An electrical signal propagates between the inspection device and the inspection object 2 via the electrical connection device 1. The wiring board 300 is, for example, a printed circuit board (PCB) or an interposer (IP) board.

The probe head 200 includes a plurality of guide plates. The probes 10 penetrate through-holes (hereinafter also referred to as "guide hole") formed in the guide plates. As illustrated in FIG. 6, the probe head 200 includes a bottom guide plate 210, a top guide plate 220, and a middle guide plate 230 arranged between the bottom guide plate 210 and the top guide plate 220. The bottom guide plate 210 faces the inspection object 2. The top guide plate 220 faces the wiring board 300. The middle guide plate 230 is arranged close to the bottom guide plate 210. A spacer 240 is disposed between an outer edge region of the bottom guide plate 210 and an outer edge region of the top guide plate 220, so that a hollow region 250 is formed in the probe head 200 between the top guide plate 220 and the middle guide plate 230. The material of the probe head 200 is, for example, ceramic.

When viewed from a surface normal direction of main surfaces of the guide plates, the position of a guide hole of the top guide plate 220, through which the same probe 10 penetrates, and the positions of guide holes of the bottom guide plate 210 and the middle guide plate 230, are shifted in a direction parallel to the main surfaces. Arrangement of the guide holes in this manner is also referred to as "offset arrangement". Due to the offset arrangement, the probe 10 is curved in the hollow region 250 by elastic deformation. Therefore, the probe 10 buckles when coming into contact with the inspection object 2. The probe 10 comes into contact with the inspection object 2 with a predetermined pressure.

The electrical connection device 1 illustrated in FIG. 6 is a vertical operation type probe card. The electrical connection device 1 and the inspection object 2 move relative to each other, and the tip members 15 arranged at the first ends 101 of the probes 10 come into contact with the inspection object 2. FIG. 6 illustrates a state in which the probes 10 are not in contact with the inspection object 2.

When the probes 10 are brought into contact with the inspection object 2 and a load is applied to the probes 10, the probes 10 are brought into contact with the inspection object 2 in a curved state. With the probe 10 in which the first arm 11 and the second arm 12 are arranged in parallel in the width direction, a magnitude of pressure applied by the probe 10 when brought into contact with the inspection object 2 can be adjusted to a predetermined magnitude. For example, the pressure applied by the probe 10 when brought into contact with the inspection object 2 may be adjusted by setting an interval between the first arm 11 and the second arm 12 in the width direction, a length of the first slit 13 in the axial direction, or the like.

When the probe 10 is curved, stress is concentrated on an end of the first slit 13 formed between the first arm 11 and the second arm 12. In other words, the stress is concentrated on the connection region in which the first arm 11 and the second arm 12 are connected to each other.

However, with the probe 10 in which the second slit 14 is formed in the connection region, the stress in the connection region is dispersed. Therefore, the probe 10 can reduce stress concentration on the end of the first slit 13.

When the probe 10 is curved, the first arm 11 and the second arm 12 may come into contact with each other in the second slit 14. However, the side surface of the first arm 11 and the side surface of the second arm 12 facing each other in the second slit 14 are tapered. Therefore, the side surface of the first arm 11 and the side surface of the second arm 12 come into contact with each other at a point when viewed in the axial direction. When the first arm 11 and the second arm 12 come into contact with each other in the second slit 14, as illustrated in FIG. 7, a side surface portion of the first arm 11 that is closest to the second arm 12, and a side surface portion of the second arm 12 that is closest to the first arm 11, are shifted in the thickness direction. Therefore, with the probe 10, the pressure applied to the first arm 11 and the second arm 12 can be reduced compared with the case where the side surface of the first arm 11 and the side surface of the second arm 12 come into contact at a surface. As a result, damages to the probe 10 can be suppressed.

As described above, in the probe 10 according to the embodiment, the second slit 14 is formed in the connection region which is an end portion of the first slit 13. By forming the second slit 14 in communication with the first slit 13 in the connection region, stress concentration on the connection region when the probe 10 is curved can be mitigated. Thus, damages to the probe 10 caused by stress concentration on the end portion of the first slit 13 can be suppressed.

### (Other Embodiments)

The present invention has been described in terms of embodiments, as described above. However, the description and drawings which form part of this disclosure should not be understood as limiting the invention. Alternative embodiments, examples, and techniques will become apparent to those skilled in the art from this disclosure.

For example, in the description above, the second slits 14 are formed on both the first end 101 and the second end 102. However, when the probe 10 is curved, a greater stress is applied to the first end 101 in contact with the inspection object 2 than to the second end 102 connected to the land 310. Therefore, the second slit 14 may be formed only in the first end 101. Further, in the description above, the tip members 15 are arranged at both the first end 101 and the second end 102. However, the tip member 15 may be arranged at only one end. For example, the tip member 15 may be arranged at only the first end 101, and the connection region of the second end 102 may be brought into contact with the land 310. Alternatively, the tip member 15 need not be arranged at either the first end 101 or the second end 102.

As described above, needless to say, the present invention includes various embodiments that are not described above.

### REFERENCE SIGNS LIST

- 10: Probe
- 11: First arm
- 12: Second arm
- 13: First slit
- 14: Second slit
- 15: Tip member
- 101: First end
- 102: Second end

## Claims

1. A probe used for inspecting electrical characteristics of an inspection object, comprising:
a first end and a second end, which are ends in an axial direction; and
a first arm and a second arm having a columnar shape and arranged in parallel in a width direction perpendicular to the axial direction to form a first slit therebetween, the first arm and the second arm extending from the first end to the second end, wherein
the first arm and the second arm are connected with each other with the first end and the second end as connection regions,
in at least one of the first end or the second end, a second slit having an opening width in the width direction narrower than the first slit is formed in the connection regions in the axial direction to communicate with the first slit,
side surfaces of the second slit are formed in a tapered shape, viewed in a cross section along the width direction, and intersect obliquely with the width direction.

2. The probe according to claim 1, wherein side surface of the second slit is formed in a tapered shape, viewed in a cross section along the axial direction, and intersects obliquely with the axial direction.

3. The probe according to claim 1 or 2, wherein, in a cross section of the first slit along the width direction, an angle formed by side surfaces of the first slit and the width direction is larger than an angle formed by the side surfaces of the second slit and the width direction.

4. The probe according to claim 1 or 2, wherein, in a cross section of the first slit along the axial direction, an angle formed by the side surface of the first slit and the axial direction is larger than an angle formed by the side surface of the second slit and the axial direction.

5. The probe according to claim 1 or 2, wherein the second slits are formed on both the first end and the second end.

6. The probe according to claim 1 or 2, wherein the second slit communicates with the first slit in a region separated from a connection position in the connection region with the first arm, and a connection position in the connection region with the second arm.

7. The probe according to claim 1 or 2, wherein
a tip member made of a material having a hardness higher than the first end is arranged at the first end, extending from the connection regions in a direction opposite to a direction in which the first arm and the second arm extend, and
the second slit is formed in the first end.
